# EUROPEAN PATENT SPECIFICATION

(11) **EP 4 581 378 B1**
(45) Date of publication and mention of the grant of the patent: **19.08.2026**
(21) Application number: 23761155.3
(22) Date of filing: 28.08.2023
(51) Int. Cl.: G01R 33/54, G01R 33/56, G06N 20/20, G06N 3/126, G06N 5/01, G06V 10/82

(54) **METHOD FOR DETERMINING AN OPTIMAL INVERSION TIME FOR AN "INVERSION RECOVERY" RADIO FREQUENCY PULSE SEQUENCE OF A MAGNETIC RESONANCE FOR ACQUIRING LATE IMAGES AFTER ADMINISTERING A PARAMAGNETIC CONTRAST MEDIUM**
VERFAHREN ZUR BESTIMMUNG EINER OPTIMALEN INVERSIONSZEIT FÜR EINE MAGNETRESONANZ-HOCHFREQUENZPULSSEQUENZ NACH VERABREICHUNG EINES PARAMAGNETISCHEN KONTRASTMITTELS
PROCÉDÉ DE DÉTERMINATION D'UN TEMPS D'INVERSION OPTIMAL POUR UNE SÉQUENCE D'IMPULSIONS RADIOFRÉQUENCE À « RÉCUPÉRATION D'INVERSION » D'UNE RÉSONANCE MAGNÉTIQUE POUR ACQUÉRIR DES IMAGES TARDIVES APRÈS ADMINISTRATION D'UN MILIEU DE CONTRASTE PARAMAGNÉTIQUE

(30) Priority: 31.08.2022 IT 202200017907
(43) Date of publication of application: 09.07.2025
(73) Proprietor: Universita' Degli Studi di Milano-Bicocca, 20126 Milano (IT); Istituto Auxologico Italiano, 20145 Milano (IT); Universita' Ca' Foscari Venezia, 30123 Venezia (VE) (IT)
(72) Inventor: BESOZZI, Daniela, 20126 Milano (IT); NOBILE, Marco, 30123 Venezia (IT); PAPETTI, Daniele, 20126 Milano (IT); TORLASCO, Camilla, 20145 Milano (IT)
(74) Representative: Botti & Ferrari S.p.A.
(86) International application number: PCT/EP2023/073475
(87) International publication number: WO 2024/046942

(56) References cited:
- US-A1- 2020 219 262
- US-B2- 10 004 425
- SEUNG SU YOON ET AL: "Automated Time Adjusted Inversion Time Selection for Late Gadolinium Enhancement Imaging - Validation and Application on Patient Datasets", PROCEEDINGS OF THE JOINT ANNUAL MEETING ISMRM-ESMRMB 2022 & ISMRT ANNUAL MEETING, LONDON, UK, 07-12 MAY 2022, ISMRM, no. 4785, 22 April 2022 (2022-04-22), UK, XP040731333

## Description

### Technical Field

The present invention refers to a method for determining the optimal inversion time for an "Inversion Recovery" radio frequency pulse sequence to be used in a magnetic resonance for acquiring late images after administering a paramagnetic contrast medium, in a so-called late imaging.

The invention particularly, but not exclusively, refers to a method for determining the optimal inversion time for an "Inversion Recovery" radio frequency pulse sequence to be used in a magnetic resonance for acquiring late images of an area of interest, in particular of the myocardium of a subject to be examined, after administering a paramagnetic contrast medium and the following description is made with reference to this field of application with the sole purpose of simplifying the exposition thereof.

### Background Art

As it is well known, the magnetic resonance is a diagnostic technique based on the application of a high intensity magnetic field and radio frequency pulse sequences to an area of the body of a subject to be examined.

Said method is widely used in the diagnostic field since it is minimally invasive, it does not require the use of ionizing radiations and allows obtaining images with an extremely high anatomical detail, possibly integrated with functional information.

Essentially, the magnetic resonance technique uses a static magnetic field (BO) generated by the magnetic resonance apparatus. In particular, the subject to be examined is positioned inside said apparatus and is thus exposed to the static magnetic field BO. Radio frequency pulses, emitted in sequence, called radio frequency pulse sequences, are superimposed to said static magnetic field BO. More particularly, the features of the used pulse sequence, such as the time which passes between a pulse and the next one, the time which passes after a pulse for detecting a signal, the duration of the pulse, the direction of the pulse and others, determine a specific effect on an organ or more in particular on a tissue thereof under study, which allows to see certain features rather than others.

In other words, based on which information needs to be acquired, different predefined radio frequency pulse sequences are used.

The application of said specifically predefined radio frequency pulse sequences and the subsequent detection of the signal determined by the so-called tissue relaxation under examination, that is its return to the magnetization previous to the application of the radio frequency pulse, allow to generate optimal images of said tissue under examination.

For all these reasons, the magnetic resonance is increasingly used for example for the examination of the myocardium, in particular in association with a paramagnetic contrast medium administered to the subject to be examined.

In this case, for the late acquired images after administering the paramagnetic contrast medium, by using the so-called "Inversion Recovery" radio frequency pulse sequences, indicated as late images, it is fundamental to establish the so-called inversion time TI, that is the time between the 180° inversion radio frequency pulse - after which the net magnetization is in a direction which is opposite to the static magnetic field BO - and the subsequent 90° excitation pulse which is necessary to obtain the magnetic resonance signal in the "Inversion Recovery" radio frequency pulse sequences, which must be established to detect the relaxation signal of a tissue under examination, in particular the myocardium.

For said late images acquired after administering a paramagnetic contrast medium, and, specifically for the so-called radio frequency pulse sequences Mag-IR ("Magnitude - Inversion Recovery") and PSIR ("Phase Sensitive Inversion Recovery"), said inversion time TI is selected so that the magnetization of the myocardium without pathology corresponds to zero in the moment of the acquisition of the signal, and therefore said tissue appears black in the acquired final image.

It is in fact well known that the kinetic of a paramagnetic contrast medium is different among different tissues, since it is determined by the histocellular composition thereof. In particular, after a certain time from the administration of a paramagnetic contrast medium, the quantity of said paramagnetic contrast medium which is present in a portion of tissue without pathology, for example a portion of myocardium without pathology, will be different with respect to the one contained in a portion of tissue with an outcoming or acute or chronical pathological process, for example myocardium with an acute or chronical or outcoming pathological process.

In particular, the elimination of said paramagnetic contrast medium through the blood cycle, that is the so-called wash-out kinetic, depends on the histocellular composition of every single tissue.

It is therefore evident that using the correct inversion time TI allows to maximize the possibility of detecting said different concentration of the paramagnetic contrast medium, showing it in the detected image, and, accordingly, distinguishing, in said image, portions with different histocellular compositions, such as for example portions of tissue without pathology with respect to portions of tissue which presents evidence of an acute or chronical or pathological or outcoming pathologic process. In particular, the resonance images are acquired in a time interval in which the contrast medium, which is paramagnetic and can be therefore easily seen by resonance, is at level so as to have, in said images, the maximum difference between a tissue without pathology and a tissue with an acute or chronical or outcoming pathological process.

Conversely, using an incorrect inversion time TI, for example too long or too short, implies a reduction in the ability of distinguishing tissues with different histocellular compositions in the detected images, thus reducing, or even invalidating, the validity of the examination carried out by using the magnetic resonance apparatus.

Until today, said inversion time TI for acquiring late images after administering a paramagnetic contrast medium with "Inversion Recovery" radio frequency pulse sequences was estimated by the operator who carries out the magnetic resonance, based on its experience and generally by "trial-and-error", which is obviously a non-optimal situation, which requires adequately trained personnel and is in particular time-consuming, the quality of the images obtained at the end of the examination with the inversion time considered by the operator as optimal being anyway not guaranteed.

From the U.S. patent publication No. US 2020/237253A1, a radio frequency pulse sequence for a magnetic resonance apparatus is known, which allows the acquisition of different images, in particular of the hearth of a subject to be examined, which uses different inversion times TI, indicated as TI scout sequence, for the test, leaving to an operator the selection of the final value for the inversion time TI to be used for the examination after a visual assessment of the series of acquired images with the different times of the TI scout sequence.

Also said known solution is anyway non-optimal and requests adequately trained personnel, since it is still time-consuming and it does not guarantee that the selection of the operator allows acquiring images of the desired quality. Furthermore, said solution requires that the subject to be examined performs an apnea that can last even 20-22 seconds, thereby causing potential inconveniences and difficulties to said subject.

A method for identification of an optimal image within a sequence of image frames is known from the article to Seung et al. entitled: "Automated Time Adjusted Inversion Time Selection for Late Gadolinium Enhancement Imaging - Validation and Application on Patient Datasets", Proceeding of the Joint Annual Meeting ISMRM-ESMRMB, 22 April 2022. Moreover, a method for identification of an optimal image within a sequence of image frames is known from the US patent publication No. US 2020/219262 A2.

It should be noted that the quality of the acquired images is fundamental. In particular, when using a non-optimal inversion time TI, the late images obtained with "Inversion Recovery" radio frequency pulse sequences after administering a paramagnetic contrast medium, which are the most important images characterizing the tissues of a subject to be examined, can be of a quality such that they do not support a possible diagnosis or even lead to an inaccurate diagnosis.

In addition to the delay that an incorrect result of this type of examination entails, the related costs and, even more particularly, the inconveniences for the subject to be examined, who could have to repeat in some cases the examination, and therefore needing to take a further quantity of paramagnetic contrast medium, which could also not be possible in some particular conditions of said subject, should be taken into account.

The technical problem of the present invention is to provide a method for determining the optimal inversion time for an "Inversion Recovery" radio frequency pulse sequence to be used in a magnetic resonance for acquiring late images of an area of interest of a subject to be examined after administering a paramagnetic contrast medium, having structural and functional features so as to automatically calculate an inversion time which is able to allow acquiring images where portions of the area of interest with different histocellular compositions are visually distinct starting from significant data of the subject to be examined and specific parameters of the carried-out examination, thereby overcoming the limitations and drawbacks which still afflict the methods made according to the prior art.

### Disclosure of Invention

The solution idea underlying the present invention is to determine an optimal inversion time value starting from the significant data of the subject to be examined and from specific parameters of the carried-out examination thanks to a machine learning model of an AI engine trained with values coming from a plurality of sample assessments, said optimal inversion time being adapted to be provided to a magnetic resonance apparatus for acquiring, with "Inversion Recovery" radio frequency pulse sequences, late images of an area of interest of the subject to be examined after administering a paramagnetic contrast medium where portions with different histocellular compositions are visibly distinct.

Based on this solution idea, the technical problem is solved by a method for determining an optimal inversion time for an "Inversion Recovery" radio frequency pulse sequence of a magnetic resonance of late images after administering a paramagnetic contrast medium which are acquired by a control and image capture device associated with a magnet structure of a magnetic resonance apparatus and connected to a computer adapted to exchange information and instructions with the control and image capture device, the method comprising a calculation sequence including:
- a first step wherein significant data of a subject to be examined and specific parameters of an examination carried out by the magnetic resonance apparatus are collected and provided as input data to the computer;
- a second step wherein the computer calculates an optimal inversion time value for the subject to be examined and for the carried-out examination by means of a machine learning model using the input data; and
- a third step wherein the optimal inversion time is provided to the control and image capture device so as to drive an acquisition of resulting late images of an area of interest which are optimized for the subject to be examined and for the carried-out examination,
the machine learning model used during the second step for calculating the optimal inversion time value being optimized in a training sequence starting from a plurality of calculated optimal inversion time values correlated to significant data of a related examined subject and specific parameters of the carried-out examination as established in the course of a plurality of sample assessments.

More in particular, the invention comprises the following additional and optional features, taken singularly or in combination, if necessary.

According to an aspect of the invention, the training sequence includes:
- a first step of acquisition of a plurality of calculated optimal inversion time values correlated to significant data of a related examined subject and specific parameters of the carried-out examination established in the course of a plurality of sample assessments;
- a second step of optimization of the machine learning model based on the calculated optimal inversion time values correlated to significant data of a related examined subject and specific parameters of the carried-out examination of the plurality of sample assessments; and
- a third step of generation of the machine learning model so optimized.

According to another aspect of the invention, the second step of optimization uses a Random Forest based regression model as machine learning model and determines optimized values of hyperparameters thereof.

More in particular, the second step of optimization uses evolutionary computing techniques for determining the optimized values of the hyperparameters of the Random Forest based regression model.

According to another aspect of the invention, the optimal inversion time is constantly updated during an examination carried out by the magnetic resonance apparatus.

Furthermore, according to an aspect of the invention, the input data are provided to the computer through an automatic transmission of the wired or wireless type or through a manual entry, preferably by using an interface of the computer.

According to another aspect of the invention, the first data are provided to the magnetic resonance apparatus through an automatic transmission of the wired or wireless type or through a manual entry, preferably by using an interface of the magnetic resonance apparatus.

In particular, the significant data of the subject to be examined comprise anthropomorphic data, including height, weight, age of the subject and clinical data, including a medical history or any medications administered to the subject.

Further, the specific parameters of the carried-out examination comprise type of paramagnetic contrast medium as used, quantities administered, timing of administration and specifications of the resonance apparatus.

According to another aspect of the invention, the resulting late images include portions of tissue of the area of interest with several clearly distinct histocellular compositions.

Preferably, the area of interest is the myocardium of the subject to be examined.

The technical problem is also solved by a magnetic resonance apparatus provided with at least one magnet structure controlled by a control and image capture device and with a computer connected to the control and image capture device associated with calculation means, wherein the computer is adapted to implement a method for determining the optimal inversion time for an "Inversion Recovery" radio frequency pulse sequence of a magnetic resonance for acquiring late images after administration of a paramagnetic contrast medium as described above, said optimal inversion time being provided to the control and image capture device to drive an acquisition of resulting late images being optimized for a subject to be examined and for an examination carried out by the magnetic resonance apparatus.

The features and advantages of the method and apparatus according to the invention will become apparent from the description, made herein in the following, of an embodiment thereof given by way of an indicative and non-limiting example with reference to the attached drawings.

### Brief Description of Drawings

In said drawings:
Figure 1: schematically shows a sectional view of a magnetic resonance apparatus, which uses an inversion time value determined by the method for determining the optimal inversion time for an "Inversion Recovery" radio frequency pulse sequence of a magnetic resonance for acquiring late images of an area of interest of a subject to be examined after administering a paramagnetic contrast medium according to the present invention;
Figure 2A: schematically shows a calculation sequence of the optimal inversion time of the method according to the present invention; and
Figure 2B: schematically shows a training sequence of the method according to the present invention.

### Modes for Carrying Out the Invention

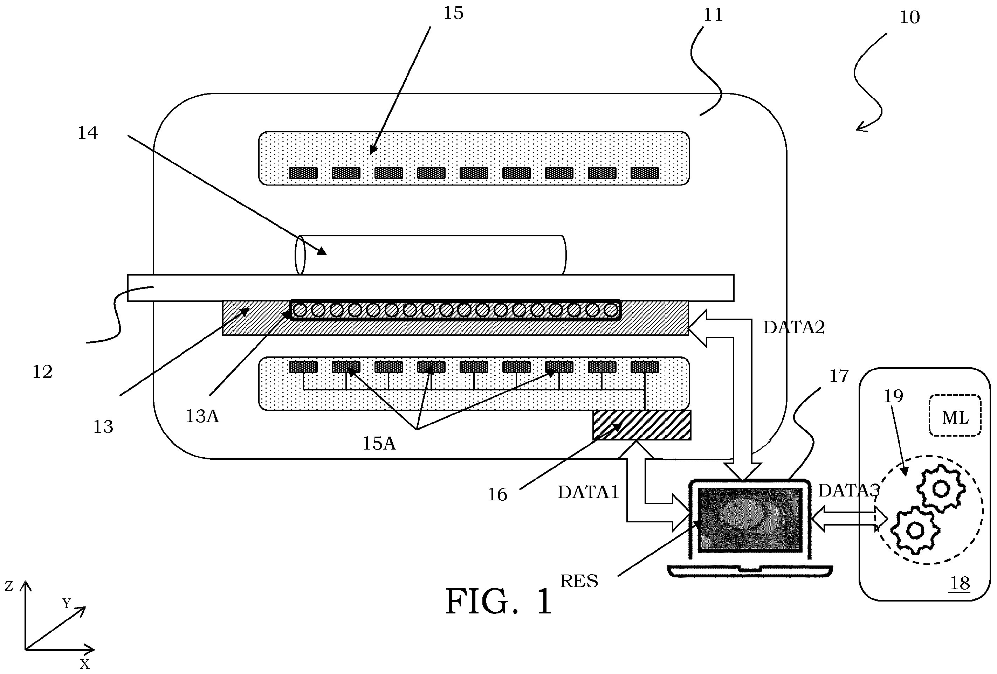

With reference to said figures, and in particular to Figure 1, a magnetic resonance apparatus is globally indicated with 10.

Said magnetic resonance apparatus 10 essentially comprises a tubular body 11 in which a table 12 is arranged which is suitably moved by movement means 13, for example with rolls 13A, and is adapted to support a subject to be examined 14.

The magnetic resonance apparatus 10 comprises a magnet structure 15 which is suitably driven by a control and image capture device 16, which is in turn connected to a computer 17.

More in particular, the magnet structure 15 comprises a plurality of magnetic coils 15A which are connected to the control and image capture device 16 and receives therefrom suitable control signals for generating a radio frequency pulse sequence which are superimposed to a static magnetic field BO generated by the tubular body 11. As explained in relation to the prior art, the radio frequency pulse sequence is selected based on the effects which it is able to produce on an area of interest of the subject to be examined 14, in a preferred example the heart tissues.

Suitably according to the present invention, the control and image capture device 16 furthermore receives, from the computer 17, a value for an optimal inversion time TI for the "Inversion Recovery" radio frequency pulse sequence which is able to ensure the acquisition of images wherein, in the area of interest of the subject to be examined 14, portions of tissue with different histocellular composition are distinct from each other, said images being late images, that is, acquired after administering a paramagnetic contrast medium.

As seen in relation to the prior art, the inversion time TI is the time between the 180° inversion radio frequency pulse - after which the net magnetization is in an opposite direction to the static magnetic field BO - and the subsequent 90° excitation pulse which is necessary to obtain the magnetic resonance signal in the "Inversion Recovery" radio frequency pulse sequences of a magnetic resonance, which must be established in order to obtain optimal images of said area of interest in which portions with different histocellular composition are visibly distinct from each other.

The computer 17 is able to exchange information and instructions, in general terms, first data DATA1 with the control and image capture device 16 and second data DATA2 with the movement means 13.

Suitably, the computer 17 is connected to calculation means 18 provided with an AI engine 19 based on a machine learning model ML with which said computer 17 exchanges third data DATA3.

As will be explained in greater detail in the continuation of the description, the machine learning model ML of the AI engine 19 is build based on optimal inversion time values correlated to significant data of the subject to be examined and specific parameters of the carried-out examination which come from a plurality of sample assessments during a step of training of the method according to the present invention. More in particular, said computer 17 together with the calculation means 18 and the AI engine 19 implements a method for determining the optimal inversion time for an "Inversion Recovery" radio frequency pulse sequence to be used in a magnetic resonance for acquiring late images of an area of interest, in particular of the myocardium, of a subject to be examined after taking a paramagnetic contrast medium according to the present invention and provides a value of said optimal inversion time to the magnetic resonance apparatus 10, in particular to the control and image capture device 16 connected to the magnet structure 15 thereof.

Among the significant data of the subject to be examined, anthropomorphic data such as height, weight, age of the subject, as well as other clinical data such as medical history or any administered medications, can be considered, whereas the specific parameters of the carried-out examination can comprise the type of paramagnetic contrast medium as used, quantities administered, timing of administrations, specifications of the resonance apparatus which carries out the examination.

The optimal inversion time value is the value which allows to obtain significant resulting images RES, that is images in which portions of tissue of the area of interest with different histocellular compositions are clearly distinct. Suitably according to the present invention, said optimal inversion time value is calculated thanks to the machine learning model ML, in particular a Random Forest based regression model optimized starting from a plurality of optimal inversion time values correlated to significant data of the subject to be examined and specific parameters of the carried-out examination which come from a plurality of sample assessments.

The method for determining the optimal inversion time for an "Inversion Recovery" radio frequency pulse sequence for acquiring late images after administrating a paramagnetic contrast medium by means of magnetic resonance according to the present invention is used for acquiring heart images after administering a paramagnetic contrast medium to a subject to be examined, and originates from the fact that, after the administration of said paramagnetic contrast medium, the heart wash-out curve depends on significant data of the subject to be examined, in particular personal and clinical data, but also specific parameters of the carried-out examination, in particular the paramagnetic contrast medium which is used and the magnet structure of the magnetic resonance apparatus which carries out the examination.

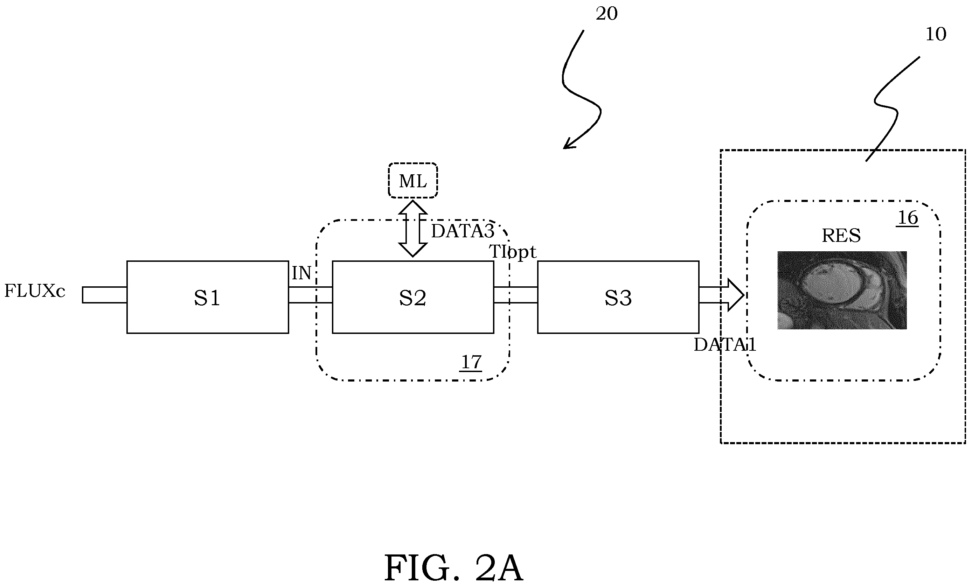

According to the present invention, the method therefore essentially comprises a calculation sequence 20, including a plurality of steps FLUXc, as schematically illustrated in Figure 2A. In particular, the calculation sequence 20 comprises:
- a first step S1 wherein significant data of the subject to be examined and specific parameters of the carried-out examination are collected and provided as input data IN to the computer 17 associated with the magnetic resonance apparatus 10;
- a second step S2 wherein the computer 17 uses a machine learning model ML for calculating an optimal inversion time value TIopt for a specific subject to be examined and for a specific examination to be carried out, that is using the input data IN; and
- a third step S3 wherein said optimal inversion time TIopt is provided as first data DATA1 to the magnetic resonance apparatus 10 and in particular to the control and image capture device 16 thereof so as to allow the acquisition of resulting late images RES optimized for the specific subject to be examined and for the specific carried-out examination.

The input data IN can be provided to the computer 17 through an automatic transmission of the wired or wireless type or through a manual entry, by using for example an interface of said computer 17 which is suitably arranged for the purpose. Analogously, the first data DATA1 can be provided to the magnetic resonance apparatus 10 and in particular to the control and image capture device 16 thereof through an automatic transmission of the wired or wireless type or through a manual entry by using for example an interface of said magnetic resonance apparatus 10.

Suitably according to the present invention, the optimal inversion time value TIopt is constantly updated through the calculation means 18 during the examination, as the time passes from the administration of the paramagnetic contrast medium up to the end of said examination.

In a preferred embodiment, the second step S2 uses a Random Forest based regression model as machine learning model ML.

As it is well known, the Random Forest model is suitably optimized by identifying the optimal values for the so-called hyperparameters which partially modify the behavior/operation and "what to give importance to" during the training in a sort of decision tree, said hyperparameters being established through optimization techniques, in particular through evolutionary computing.

The evolutionary computing is substantially a calculation process in which a plurality of hyperparameter combinations is tested and a subset of combinations, identified as the best ones, is selected, subsequently generating other combinations starting from the selected ones and iterating the entire process up to the identification of the optimal values of the hyperparameters of said Random Forest model.

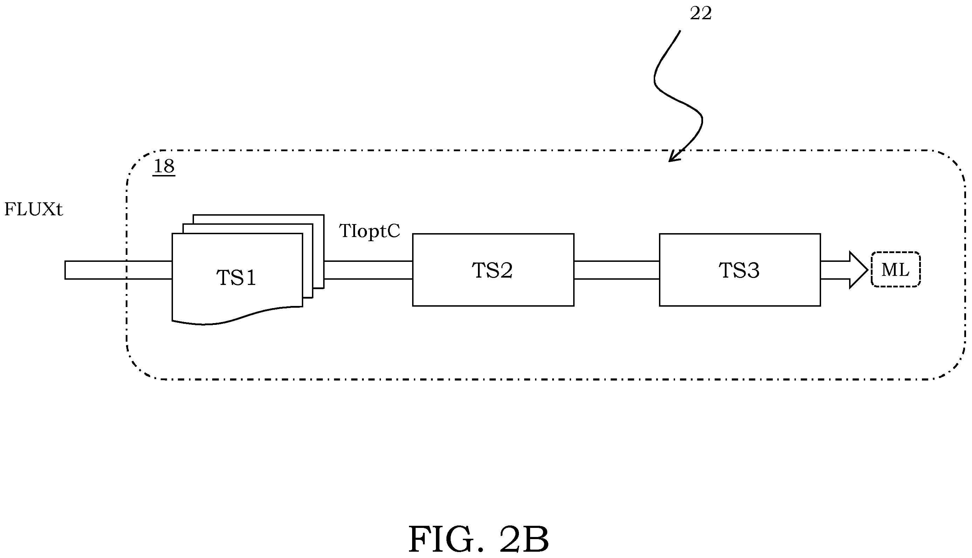

Suitably according to the present invention, the machine learning model ML is optimized in a learning sequence 22 of the method according to the present invention, which is schematically illustrated in Figure 2B, starting from calculated optimal inversion time values and from corresponding significant data of the subject to be examined and specific parameters of the carried-out examination as established in the course of a plurality of sample assessments carried out by specialized personnel.

The training sequence 22 comprises a plurality of steps FLUXt, particularly including:
- a first step TS1 of acquisition of a plurality of calculated optimal inversion time values TIoptC correlated to significant data of a related examined subject and specific parameters of the carried-out examination established in the course of a plurality of sample assessments;
- a second step TS2 of optimization of a machine learning model ML based on said calculated optimal inversion time values TIoptC correlated to significant data of a related examined subject and specific parameters of the carried-out examination of the plurality of sample assessments; and
- a third step TS3 of generation of said machine learning model ML so optimized.

Suitably, using a Random Forest based regression model as machine learning model ML, the second step TS2 of optimization establishes the values of the hyperparameters thereof, in particular optimized through evolutionary computing techniques.

The so-optimized machine learning model ML is then used by the calculation means 18 of the computer, and in particular by the AI engine 19, for calculating the optimal inversion time value TIopt for a specific subject to be examined and for a specific examination to be carried out starting from the input data IN.

In other words, the method for determining the optimal inversion time for an "Inversion Recovery" radio frequency pulse sequence for acquiring late images through magnetic resonance after administration of a paramagnetic contrast medium according to the present invention receives, as input, the significant data of the subject to be examined and the specific parameters of the carried-out examination, which affect the kinetic of the paramagnetic contrast medium, in addition to the time passed since the administration of the paramagnetic contrast medium and, based on said data, provides an optimal inversion time TIopt, which is customized on the profile of the subject to be examined and of the examination to be carried out, and is to be used for acquiring late images, which are of a high quality and diagnostically significant, by means of the magnetic resonance apparatus 10.

Clinical tests show that the method for determining the optimal inversion time for an "Inversion Recovery" radio frequency pulse sequence of a magnetic resonance according to the present invention is able to calculate the optimal inversion time values with an accuracy comparable to that of a skilled operator. Therefore, the use of said method reduces the operator-dependency of the magnetic resonance diagnostics as a whole.

Suitably, the method according to the present invention therefore reduces the number of images which must be acquired several times to optimize the quality, that is the contrast between portions with different histocellular composition, and keeps unchanged, and possibly reduces, the overall duration of the examination.

Obviously, a person skilled in the art can make various modifications and variations to the method described above, in order to satisfy contingent and specific needs, all being included in the scope of protection of the invention as defined by the following claims.

## Claims

1. Method for determining an optimal inversion time for an "Inversion Recovery" radio frequency pulse sequence of a magnetic resonance for acquiring late images after administering a paramagnetic contrast medium by means of a control and image capture device (16) associated with a magnet structure (15) of an apparatus for magnetic resonance (10) and connected to a computer (17) adapted to exchange information and instructions (DATA1) with said control and image capture device (16), said method comprising a calculation sequence (20) including:
- a first step (S1) wherein significant data of a subject to be examined and specific parameters of an examination carried out by said magnetic resonance apparatus (10) are collected and provided as input data (IN) to said computer (17);
- a second step (S2) wherein said computer (17) calculates an optimal inversion time value (TIopt) for said subject to be examined and for said carried-out examination by means of a machine learning model (ML) using said input data (IN); and
- a third step (S3) wherein said optimal inversion time (TIopt) is provided to said control and image capture device (16) so as to drive an acquisition of resulting late images (RES) of an area of interest which are optimized for said subject to be examined and for said carried-out examination,
said machine learning model (ML) used during said second step (S2) for calculating said optimal inversion time value (TIopt) being optimized in a training sequence (22) starting from a plurality of calculated optimal inversion time values (TIoptC) correlated to significant data of a related examined subject and specific parameters of the carried-out examination as established in the course of a plurality of sample assessments.

2. Method according to claim 1, wherein said training sequence (22) includes:
- a first step (TS1) of acquisition of a plurality of calculated optimal inversion time values (TIoptC) correlated to significant data of a related examined subject and specific parameters of the carried-out examination established in the course of a plurality of sample assessments;
- a second step (TS2) of optimization of said machine learning model (ML) based on said calculated optimal inversion time values (TIoptC) correlated to significant data of a related examined subject and specific parameters of the carried-out examination of the plurality of sample assessments; and
- a third step (TS3) of generation of said machine learning model (ML) so optimized.

3. Method according to claim 2, wherein said second step (TS2) of optimization uses a Random Forest based regression model as machine learning model (ML) and determines optimized values of hyperparameters thereof.

4. Method according to claim 3, wherein said second step (TS2) of optimization uses evolutionary computing techniques for determining said optimized values of said hyperparameters of said Random Forest based regression model.

5. Method according to any one of the preceding claims, wherein said optimal inversion time (TIopt) is constantly updated during an examination carried out by said magnetic resonance apparatus (10).

6. Method according to any one of the preceding claims, wherein said input data (IN) are provided to said computer (17) through an automatic transmission of the wired or wireless type or through a manual entry, preferably by using an interface of said computer (17).

7. Method according to any one of the preceding claims, wherein said first data (DATA1) are provided to said magnetic resonance apparatus (10) through an automatic transmission of the wired or wireless type or through a manual entry, preferably by using an interface of said magnetic resonance apparatus (10).

8. Method according to any one of the preceding claims, wherein said significant data of said subject to be examined comprise anthropomorphic data, including height, weight, age of said subject and clinical data, including a medical history or any medications administered to said subject.

9. Method according to any one of the preceding claims, wherein said specific parameters of the carried-out examination comprise type of paramagnetic contrast medium as used, quantities administered, timing of administration and specifications of said resonance apparatus (10).

10. Method according to any one of the preceding claims, wherein said resulting late images (RES) include portions of tissue of said area of interest with several clearly distinct histocellular compositions.

11. Method according to any one of the preceding claims, wherein said area of interest is the myocardium of said subject to be examined.

12. Magnetic resonance apparatus (10) provided with at least one magnet structure (15) controlled by a control and image capture device (16) and with a computer (17) connected to said control and image capture device (16) associated with calculation means (18), wherein said computer (17) is adapted to implement a method for determining the optimal inversion time for an "Inversion Recovery" radio frequency pulse sequence of a magnetic resonance for acquiring late images after administration of a paramagnetic contrast medium according to any one of the preceding claims, said optimal inversion time (TIopt) being provided to said control and image capture device (16) to drive an acquisition of resulting late images (RES) being optimized for a subject to be examined and for an examination carried out by said magnetic resonance apparatus (10).

## Patentansprüche

1. Verfahren zur Bestimmung einer optimalen Inversionszeit für eine "Inversion Recovery"-Hochfrequenzpulssequenz einer Magnetresonanz zur Erfassung von Late-Bildern nach Verabreichung eines paramagnetischen Kontrastmittels mittels einer Steuer- und Bildaufnahmevorrichtung (16), die einer Magnetstruktur (15) eines Magnetresonanzgeräts (10) zugeordnet ist und mit einem Computer (17) verbunden ist, der dazu geeignet ist, Informationen und Anweisungen (DATA1) mit der Steuer- und Bildaufnahmevorrichtung (16) auszutauschen, wobei das Verfahren eine Berechnungssequenz (20) umfasst, die einschließt:
- einen ersten Schritt (S1), wobei signifikante Daten eines zu untersuchenden Subjekts und spezifische Parameter einer durch das Magnetresonanzgerät (10) durchgeführten Untersuchung gesammelt und dem Computer (17) als Eingabedaten (IN) bereitgestellt werden;
- einen zweiten Schritt (S2), wobei der Computer (17) mittels eines Modells maschinellen Lernens (ML) unter Verwendung der Eingabedaten (IN) einen optimalen Inversionszeit-Wert (TIopt) für das zu untersuchende Subjekt und für die durchgeführte Untersuchung berechnet; und
- einen dritten Schritt (S3), wobei die optimale Inversionszeit (TIopt) der Steuer- und Bildaufnahmevorrichtung (16) bereitgestellt wird, um ein Erfassen resultierender Late-Bilder (RES) eines Bereichs von Interesse zu steuern, die für das zu untersuchende Subjekt und für die durchgeführte Untersuchung optimiert sind,
wobei das Modell maschinellen Lernens (ML), das während des zweiten Schritts (S2) zur Berechnung des optimalen Werts der Inversionszeit (TIopt) verwendet wird, in einer Trainingssequenz (22) optimiert wird, die von einer Mehrzahl berechneter optimaler Werte der Inversionszeit (TIoptC) ausgeht, die mit signifikanten Daten eines zugehörigen untersuchten Subjekts und spezifischen Parametern der durchgeführten Untersuchung korreliert sind, wie sie im Verlauf einer Mehrzahl von Stichprobenbeurteilungen ermittelt wurden.

2. Verfahren nach Anspruch 1, wobei die Trainingssequenz (22) umfasst:
- einen ersten Schritt (TS1) des Erfassens einer Mehrzahl berechneter optimaler Werte der Inversionszeit (TIoptC), die mit signifikanten Daten eines zugehörigen untersuchten Subjekts und spezifischen Parametern der durchgeführten Untersuchung korreliert sind, wie sie im Verlauf einer Mehrzahl von Stichprobenbeurteilungen ermittelt wurden;
- einen zweiten Schritt (TS2) des Optimierens des Modells maschinellen Lernens (ML) basierend auf den berechneten optimalen Werten der Inversionszeit (TIoptC), die mit signifikanten Daten eines zugehörigen untersuchten Subjekts und spezifischen Parametern der durchgeführten Untersuchung der Mehrzahl von Stichprobenbeurteilungen korreliert sind; und
- einen dritten Schritt (TS3) des Generierens des so optimierten Modells maschinellen Lernens (ML).

3. Verfahren nach Anspruch 2, wobei der zweite Schritt (TS2) des Optimierens ein auf Random Forest basierendes Regressionsmodell als Modell maschinellen Lernens (ML) verwendet und optimierte Werte von dessen Hyperparametern bestimmt.

4. Verfahren nach Anspruch 3, wobei der zweite Schritt (TS2) des Optimierens evolutionäre Rechentechniken zur Bestimmung der optimierten Werte der Hyperparameter des auf Random Forest basierenden Regressionsmodells verwendet.

5. Verfahren nach einem der vorhergehenden Ansprüche, wobei die optimale Inversionszeit (TIopt) während einer durch das Magnetresonanzgerät (10) durchgeführten Untersuchung kontinuierlich aktualisiert wird.

6. Verfahren nach einem der vorhergehenden Ansprüche, wobei die Eingabedaten (IN) dem Computer (17) durch eine automatische Übertragung drahtgebundener oder drahtloser Art oder durch eine manuelle Eingabe bereitgestellt werden, vorzugsweise unter Verwendung einer Schnittstelle des Computers (17).

7. Verfahren nach einem der vorhergehenden Ansprüche, wobei die ersten Daten (DATA1) dem Magnetresonanzgerät (10) durch eine automatische Übertragung drahtgebundener oder drahtloser Art oder durch eine manuelle Eingabe bereitgestellt werden, vorzugsweise unter Verwendung einer Schnittstelle des Magnetresonanzgeräts (10).

8. Verfahren nach einem der vorhergehenden Ansprüche, wobei die signifikanten Daten des zu untersuchenden Subjekts anthropomorphe Daten umfassen, einschließlich Größe, Gewicht, Alter des Subjekts, sowie klinische Daten, einschließlich einer Krankengeschichte oder etwaiger dem Subjekt verabreichter Medikamente.

9. Verfahren nach einem der vorhergehenden Ansprüche, wobei die spezifischen Parameter der durchgeführten Untersuchung einen Typ des verwendeten paramagnetischen Kontrastmittels, verabreichte Mengen, einen Zeitpunkt der Verabreichung und Spezifikationen des Resonanzgeräts (10) umfassen.

10. Verfahren nach einem der vorhergehenden Ansprüche, wobei die resultierenden Late-Bilder (RES) Gewebeanteile des Bereichs von Interesse mit mehreren klar unterscheidbaren histozellulären Zusammensetzungen umfassen.

11. Verfahren nach einem der vorhergehenden Ansprüche, wobei der Bereich von Interesse das Myokard des zu untersuchenden Subjekts ist.

12. Magnetresonanzgerät (10), das mit mindestens einer Magnetstruktur (15), die durch eine Steuer- und Bildaufnahmevorrichtung (16) gesteuert wird, und mit einem Computer (17) versehen ist, der mit der Steuer- und Bildaufnahmevorrichtung (16) verbunden ist, die Berechnungsmitteln (18) zugeordnet ist, wobei der Computer (17) dazu geeignet ist, ein Verfahren zur Bestimmung der optimalen Inversionszeit für eine "Inversion Recovery"-Hochfrequenzpulssequenz einer Magnetresonanz zur Erfassung von Late-Bildern nach Verabreichung eines paramagnetischen Kontrastmittels gemäß einem der vorhergehenden Ansprüche zu implementieren, wobei die optimale Inversionszeit (TIopt) der Steuer- und Bildaufnahmevorrichtung (16) bereitgestellt wird, um eine Erfassung resultierender Late-Bilder (RES) zu steuern, die für ein zu untersuchendes Subjekt und für eine durch das Magnetresonanzgerät (10) durchgeführte Untersuchung optimiert sind.

## Revendications

1. Procédé de détermination d'un temps d'inversion optimal pour une séquence d'impulsions radiofréquence à « récupération d'inversion » d'une résonance magnétique pour acquérir des images tardives après administration d'un milieu de contraste paramagnétique au moyen d'un dispositif de commande et de capture d'image (16) associé à une structure d'aimant (15) d'un appareil à résonance magnétique (10) et relié à un ordinateur (17) adapté pour échanger des informations et des instructions (DATA1) avec ledit dispositif de commande et de capture d'image (16), ledit procédé comprenant une séquence de calcul (20) comprenant :
- une première étape (S1) dans lequel des données significatives d'un sujet à examiner et des paramètres spécifiques d'un examen réalisé par ledit appareil à résonance magnétique (10) sont collectés et fournis en tant que données d'entrée (IN) audit ordinateur (17) ;
- une deuxième étape (S2) dans lequel ledit ordinateur (17) calcule une valeur de temps d'inversion optimal (TIopt) pour ledit sujet à examiner et pour ledit examen réalisé au moyen d'un modèle d'apprentissage automatique (ML) en utilisant lesdites données d'entrée (IN) ; et
- une troisième étape (S3) dans lequel ledit temps d'inversion optimal (TIopt) est fourni audit dispositif de commande et de capture d'image (16) de sorte à piloter une acquisition d'images tardives résultantes (RES) d'une zone d'intérêt qui sont optimisées pour ledit sujet à examiner et pour ledit examen réalisé,
ledit modèle d'apprentissage automatique (ML) utilisé pendant ladite deuxième étape (S2) pour calculer ladite valeur de temps d'inversion optimal (TIopt) étant optimisé dans une séquence d'entraînement (22) à partir d'une pluralité de valeurs de temps d'inversion optimal calculées (TIoptC) corrélées à des données significatives d'un sujet examiné lié et à des paramètres spécifiques de l'examen réalisé telles qu'établies au cours d'une pluralité d'évaluations d'échantillons.

2. Procédé selon la revendication 1, dans lequel ladite séquence d'entraînement (22) comprend :
- une première étape (TS1) d'acquisition d'une pluralité de valeurs de temps d'inversion optimal calculées (TIoptC) corrélées à des données significatives d'un sujet examiné lié et à des paramètres spécifiques de l'examen réalisé établies au cours d'une pluralité d'évaluations d'échantillons ;
- une deuxième étape (TS2) d'optimisation dudit modèle d'apprentissage automatique (ML) sur la base desdites valeurs de temps d'inversion optimal calculées (TIoptC) corrélées à des données significatives d'un sujet examiné lié et à des paramètres spécifiques de l'examen réalisé de la pluralité d'évaluations d'échantillons ; et
- une troisième étape (TS3) de génération dudit modèle d'apprentissage automatique (ML) ainsi optimisé.

3. Procédé selon la revendication 2, dans lequel ladite deuxième étape (TS2) d'optimisation utilise un modèle de régression basé sur les forêts aléatoires en tant que modèle d'apprentissage automatique (ML) et détermine des valeurs optimisées d'hyperparamètres de celui-ci.

4. Procédé selon la revendication 3, dans lequel ladite deuxième étape (TS2) d'optimisation utilise des techniques d'informatique évolutionniste pour déterminer lesdites valeurs optimisées desdits hyperparamètres dudit modèle de régression basé sur les forêts aléatoires.

5. Procédé selon l'une quelconque des revendications précédentes, dans lequel ledit temps d'inversion optimal (TIopt) est constamment mis à jour pendant un examen réalisé par ledit appareil à résonance magnétique (10).

6. Procédé selon l'une quelconque des revendications précédentes, dans lequel lesdites données d'entrée (IN) sont fournies audit ordinateur (17) par l'intermédiaire d'une transmission automatique de type filaire ou sans fil ou par l'intermédiaire d'une entrée manuelle, de préférence en utilisant une interface dudit ordinateur (17).

7. Procédé selon l'une quelconque des revendications précédentes, dans lequel lesdites premières données (DATA1) sont fournies audit appareil à résonance magnétique (10) par l'intermédiaire d'une transmission automatique de type filaire ou sans fil ou par l'intermédiaire d'une entrée manuelle, de préférence en utilisant une interface dudit appareil à résonance magnétique (10).

8. Procédé selon l'une quelconque des revendications précédentes, dans lequel lesdites données significatives dudit sujet à examiner comprennent des données anthropomorphiques, comprenant la taille, le poids, l'âge dudit sujet et des données cliniques, comprenant des antécédents médicaux ou tout médicament administré audit sujet.

9. Procédé selon l'une quelconque des revendications précédentes, dans lequel lesdits paramètres spécifiques de l'examen réalisé comprennent un type de milieu de contraste paramagnétique tel qu'utilisé, des quantités administrées, une chronologie d'administration et des spécifications dudit appareil à résonance (10).

10. Procédé selon l'une quelconque des revendications précédentes, dans lequel lesdites images tardives résultantes (RES) comprennent des parties de tissu de ladite zone d'intérêt avec plusieurs compositions histocellulaires clairement distinctes.

11. Procédé selon l'une quelconque des revendications précédentes, dans lequel ladite zone d'intérêt est le myocarde dudit sujet à examiner.

12. Appareil à résonance magnétique (10) pourvu d'au moins une structure d'aimant (15) commandée par un dispositif de commande et de capture d'image (16) et d'un ordinateur (17) relié audit dispositif de commande et de capture d'image (16) associé à un moyen de calcul (18), dans lequel ledit ordinateur (17) est adapté pour mettre en œuvre un procédé de détermination du temps d'inversion optimal pour une séquence d'impulsions radiofréquence à « récupération d'inversion » d'une résonance magnétique pour acquérir des images tardives après administration d'un milieu de contraste paramagnétique selon l'une quelconque des revendications précédentes, ledit temps d'inversion optimal (TIopt) étant fourni audit dispositif de commande et de capture d'image (16) pour piloter une acquisition d'images tardives résultantes (RES) étant optimisées pour un sujet à examiner et pour un examen réalisé par ledit appareil à résonance magnétique (10).
